# EUROPEAN PATENT APPLICATION

(11) **EP 4 819 197 A1**
(43) Date of publication of application: **07.10.2026**
(21) Application number: 25305492.8
(22) Date of filing: 03.04.2025
(51) Int. Cl.: H01L 21/02, H01L 21/268, H01L 21/762, B23K 26/00, B23K 26/53

(54) **A METHOD FOR MANUFACTURING A SILICON CARBIDE ON INSULATOR**

(71) Applicant: Université de Strasbourg, 67000 Strasbourg (FR); Centre National de la Recherche Scientifique, 75016 Paris (FR); Institut National des Sciences Appliquées de Strasbourg, 67000 Strasbourg (FR); Industrialisation des Recherches sur les Procédés et les Applications du Laser, 67400 Illkirch-Graffenstaden (FR)
(72) Inventor: TRIBOLLET, Jérôme, 67037 STRASBOURG (FR); LECLER, Sylvain, 67412 ILLKIRCH (FR); BAHOUKA, Armel, 67412 ILLKIRCH (FR); PALLARES ALDEITURRIAGA, David, 67412 ILLKIRCH (FR); ROQUES, Stéphane, 67037 STRASBOURG (FR)
(74) Representative: Gevers & Orès

(57) **Abstract**

The invention relates to a method for manufacturing a silicon carbide on insulator, said method comprising the following steps:
a) providing a substrate,
b) providing a silicon carbide structure,
at least one of the substrate and of the silicon carbide structure being provided with an electrically insulating layer;
c) arranging the silicon carbide structure against the substrate with the electrically insulating layer between them so as to form a contact between them;
d) focusing a laser beam towards the electrically insulating layer to weld the silicon carbide structure to the substrate, the laser beam being controlled to define one or several welded areas separated by one or several non-welded areas.

The invention also relates to a method for manufacturing SiCOI photonic structures that may contain one or several color centers, from a SiCOI structure obtained with the manufacturing method of the invention.

## Description

### Technical field of the invention

The invention relates to the manufacturing of silicon carbide on insulator (SiCOI).

### Prior art

The development of quantum technologies is a strategic concern.

Quantum technologies may be used to create sensors, to encrypt and secure information communication or to perform calculations much faster than a conventional computer. Indeed, in a conventional computer, the elementary unit of information is coded in two states, called 'bits': 0 and 1. In a quantum computer, the elementary unit of information, called a Qubit, is encoded in 2 quantum states, usually called |0> and |1>. In quantum logic, the unit of information known as a Qubit can be in a superposition of quantum states, and there is then, at a given moment, only a probability of being in one of these states. A set of N Qubits, forming a quantum register, can itself be in a superposition of 2^{N} basic quantum states of the register. Since the unitary operations applied to the quantum register are linear, quantum computation is therefore massively parallel, which is exploited in most quantum algorithms to outperform classical computers in solving certain types of problem.

The photon, or qubit of light, with its spin state |+1> or |-1> is a good candidate for carrying the information of a Qubit. At a macroscopic scale, the spin state of the photon corresponds to the polarization of light. Other material qubits exist, such as qubits encoded on the ground state and the excited electronic state of an atom or molecule, or those encoded on two distinct electronic spin states of a defect located in a crystal, called a "color center". In particular, a photon can excite this color center or, conversely, a de-excited color center can emit a photon. A color center, when it is both photoluminescent (photon emitter) and carries a non-zero electron spin, can be an excellent source of single photons, as well as an excellent material quantum memory. Combined with spin state conserving optical transitions, such a color center can then provide an excellent interface between a light qubit (photon) and a material qubit (spin). Also, taking advantage of the low loss of transmitted single photons in dedicated optical waveguides and/or optical fibers and using strategies like two photon entanglement experiments, materials containing such color centers, when associated with optical waveguides and/or optical cavities, can provide a very efficient approach and quantum material platform for large scale quantum computing. In this context, material platforms offering both color centers and optical waveguides and cavities on the same chip are advantageous. A single or several color centers in such material platforms can also be used as very efficient and nanoscale quantum probes of their nearby environment and thus be used in various kinds of quantum sensors. They can offer advantageous high spatial resolution and/or high sensitivity for sensing various physical or chemical parameters, such as temperature, magnetic field or electric field, pressure, microwaves, or simply other nearby spins.

To achieve, in particular, a large-scale quantum processor based on quantum computation distributed over several quantum sub-processors, known as quantum nodes, it is necessary to have single-photon sources, single-photon detectors, means of guiding the light with little loss, and an efficient spin-photon interface allowing a light qubit (photon) to interact with a material qubit (coded, for example, on the electron spin of a color center) in a correlated manner. For example, an optical absorption depending on the spin state of the material Qubit in its fundamental electronic state can occur during the quantum information process, the electronic spin state being itself controlled by resonant microwave pulses sequences using magnetic resonance methods, often called ODMR (for "Optically Detected Magnetic Resonance"), when combined with optical detection of the spin state of the color center by photoluminescence.

Three main technologies are currently being explored in this context.

The first technology is the "silicon technology". Forming a silicon (Si) semiconductor layer on an insulating silicon oxide layer (SiO₂), light can be guided by means of the optical refractive index contrast (total internal reflection) between those two materials. This advanced material is known as SOI (Silicon on insulator). By creating defects in the silicon crystal, we can make color centers that can be used as single-photon sources, i.e. light Qubits. The main drawback of this technology lies in the fact that the best-known and most promising of these centers do not carry a non-zero electron spin and therefore lack the spin-photon interface that is useful for storing quantum information and/or dynamic correction of the unavoidable errors occurring in operating quantum processors.

The second technology is based on "diamond color centers". These color centers are emitters of single photons and carriers of electron spins, on which Qubits can be encoded. Nevertheless, they are either introduced into a diamond monocrystal, currently limited in volume to a few mm³, or into nanodiamonds, which in both cases limits their integration on a chip, as this requires a transfer of the diamond Qubits to another integrated photonic platform, enabling them to be optically connected, with unavoidable optical losses at the interface between these different materials when the Qubits are transferred, and a limited transfer success rate.

The third technology is based on "silicon carbide (SiC) color centers". Crystalline SiC behave in a similar way to diamond in that some of its defects can form color centers Qubits, which are both sources of single photons and non-zero electron spin material quantum memory, thus offering an excellent spin-photon interface. Examples of such color centers in 4H SiC, one of the many polytypes existing for SiC and usable for creating color centers, are the silicon vacancies color centers (of V2 or V1 type), the divacancies (VV) and the NV color centers of SiC, all paramagnetic and photoluminescent. With regard to diamond, the advantage of SiC is that it can be manufactured with advanced microelectronics technologies, already used for power electronics. It thus allows an integration on a SiC chip without any transfer to another integrated photonics platform. The current drawback of this technology lies in the difficulty of producing high crystalline quality SiC on insulator, a composite material called SiCOI for 'SiC on insulator' (by analogy with SOI for the "silicon on insulator" technology). SiCOI is needed both to guide light, taking advantage of the refractive index contrast between SiC and the insulator, generally SiO₂ , as in the case of SOI (which uses the refractive index contrast between Si and SiO₂), and also to provide a high-quality SiC crystalline environment for the color centers created in it, enabling them to maintain their known excellent optical and spin quantum coherence properties necessary for the quantum applications considered, not only in a simple bidimensional SiC structure of a SiCOl, but also and more importantly, in a SiCOI photonic structure like optical SiCOI waveguides and cavities.

Finally, it is to be noted that SiCOI manufacturing processes already exist.
- SOITEC's Smart Cut^{™} SiCOI process (WO2021/105575 A1),
- the process of bonding standard substrates by fusion under high-temperature thermal annealing (ex.: US2020/0279767 A1),
- the low-temperature bonding process with surface activation of oxides.

All these processes present drawbacks for quantum technologies.

### Summary of the invention

An aim of the present invention is to provide a method for manufacturing a silicon carbide on insulator (SiCOI) capable of overcoming at least one drawback of the current technologies.

To reach that aim the invention proposes a method for manufacturing a silicon carbide on insulator structure, said method comprising the following steps:
a) providing a substrate,
b) providing a silicon carbide structure,
   at least one of the substrate and of the silicon carbide structure being provided with an electrically insulating layer;
c) arranging the silicon carbide structure against the substrate with the electrically insulating layer between the silicon carbide structure and the substrate so as to form a contact between them ;
d) focusing a laser beam towards the electrically insulating layer to weld the silicon carbide structure to the substrate, the laser beam being controlled to define one or several welded areas separated by one or several non-welded areas.

The invention also proposes the following steps, taken alone or in combination:
- the substrate is chosen among: a material comprising silicon, for example silicon, silicon carbide or a composite structure such as a silicon-on- insulator or a silicon substrate comprising a Si(Si-a)/SiO₂ multi-layers Distributed Bragg Reflector; a material comprising gallium, for example a Gallium Nitride or Gallium Arsenide, or a Gallium Arsenide substrate comprising a multi-layers Distributed Bragg Reflector made of epitaxial layers of III-V arsenide semiconductors, a GaN substrate comprising a multi-layers Distributed Bragg Reflector made of epitaxial layers of III-V nitrides semiconductors; or a material comprising Indium, for example an Indium Phosphide substrate or an Indium Phosphide substrate comprising a multi-layers Distributed Bragg Reflector made of epitaxial layers of AlAsSb/Al_{0.04}Ga_{0.96}AsSb;
- the silicon carbide structure is made of a silicon carbide polytype, for example, 4H, 6H or 3C silicon carbide polytype;
- the substrate is provided with the electrically insulating layer;
- the electrically insulating layer is made of a material chosen among: silicon oxide such as silicon dioxide, silicon nitride such as trisilicon tetranitride, alumina, titanium dioxide, zinc oxide, magnesium oxide, strontium titanate, or a combination of electrically insulating oxides, for example made of any combination of the precited oxide materials;
- during step d), the laser beam is focused towards the electrically insulating layer through the silicon carbide structure;
- said method comprises at least one additional step consisting of thinning the silicon carbide layer, for example by reactive ion etching, mechanical grinding, mechanical chemical polishing or by a combination of any of them;
- said method implementing the following sub-steps, after step b), in this order: thinning the silicon carbide structure, down to a first thickness; implementing step c); focusing a first laser beam towards said electrically insulating layer, said first laser beam, controlled to define welded areas separated by non-welded areas, having a first beam diameter and a first Rayleigh length; thinning again the silicon carbide layer, down to a second thickness smaller than the first thickness; focusing a second laser beam towards the electrically insulating layer, said second laser beam, controlled to define welded areas separated by non-welded areas, having a second beam diameter lower than the first beam diameter and a second Rayleigh length lower than the first Rayleigh length;
- the silicon carbide structure provided at step b) having a thickness greater than 200 microns, the first thickness is comprised between 100 and 150 microns and the second thickness is smaller or equal to 20 microns, in particular smaller or equal to 1 micron;
- the method further implements, after the sub-step consisting of focusing the second laser beam towards the electrically insulating layer, an additional sub-step consisting of thinning again the silicon carbide, down to a third thickness smaller than the second thickness;
- the silicon carbide structure provided at step b) having a thickness greater than 200 microns, the first thickness is comprised between 100 and 150 microns, the second thickness is between 1 micron and 20 microns and the third thickness is less than 1 micron;
- the first laser beam has a first beam diameter greater than 20 microns and a first Rayleigh length greater than 200 microns; the second laser beam has a second beam diameter lower than 5 microns and a second Rayleigh length lower than 100 microns;
- the first laser beam is controlled to weld peripheral areas of the silicon carbide structure and of the substrate while the second laser beam is controlled to weld center areas of the silicon carbide structure and of the substrate.

The invention also proposes a method for manufacturing a photonic structure in a silicon carbide on insulator structure, said method comprising the following steps:
A) manufacturing a silicon carbide on insulator structure with the method according to the invention;
B') etching at least the silicon carbide structure at the level of at least one welded area between the silicon carbide structure and the substrate while leaving at least one part of silicon carbide at the level of said at least one welded area between the silicon carbide structure and the substrate, to form the photonic structure, for example a rib photonic waveguide or a rib photonic cavity.

The invention additionally proposes a method for manufacturing a photonic structure in a silicon carbide on insulator structure, said method comprising the following steps:
A) manufacturing a silicon carbide on insulator structure with the method according to the invention;
B) etching at least the silicon carbide structure at the level of at least one non-welded area between the silicon carbide structure and the substrate, to form the photonic structure.

These methods for manufacturing a photonic structure may also implement the following steps:
- preparatory steps to step B), between step A) and step B): PB1) locating the or each mark left by the or each welded area between the silicon carbide structure and the substrate, PB2) manufacturing, by lithography, a mask not covering at least one non-welded area between the silicon carbide and the substrate, by taking advantage of the or each mark previously located;
- step B) also implies etching of the electrically insulating layer, and eventually of the substrate, at the level of at least one non-welded area between the silicon carbide structure and the substrate;
- the electrically insulating layer being made of silicon oxide (SiOx), step B) consists of etching by reactive ion etching the silicon carbide structure through the mask defined by lithography until at least reaching the silicon oxide electrically insulating layer, and then etching at least partially the silicon oxide electrically insulating layer with a HF solution or with HF vapors;
- an additional step consisting of: C) performing ion implantation of the silicon carbide structure at the level of at least one non-welded area between the silicon carbide structure and the substrate to form at least one color center in a photonic structure, said step being for example made with a focused ion beam or a helium ion microscope; and eventually another additional step implemented after step C) consisting of D) performing a thermal annealing under neutral gas, for example under argon or nitrogen gas, to activate one or several color centers;
- Alternatively, an additional step consisting of C) performing electron irradiation, or neutron irradiation, or laser irradiation in such a way that laser welding is avoided, of the silicon carbide structure at the level of at least one non-welded area between the silicon carbide structure and the substrate to form at least one color center in a photonic structure, and eventually performing a thermal annealing;
- the method may also comprise an additional step, between step A) and step C), consisting of performing a thermal annealing of the SiCOI at 1100°C under oxygen during a predetermined duration.

Other aims and advantages of the invention will appear in the detailed description.

### Brief description of the figures

The invention will be better understood with the help of the description that follows only provided as an example and carried out by reference to the annexed drawings in which:
- Figure 1 is a block diagram representing the main steps of a method for manufacturing a SiCOI according to the invention;
- Figure 2 is a scheme representing a SiCOI obtained by the method of figure 1;
- Figure 3 is a scheme representing the SiCOI during manufacturing at different steps of the method of figure 1, for specific materials;
- Figure 4 is a view, with an optical microscope, of an example of laser welding obtained with the method of figure 1;
- Figure 5 is a scheme showing the obtention of a photonic structure, in the form of a micro-disk, in the SiCOI obtained with the method of figure 1;
- Figure 6 is a scheme showing the obtention of a photonic structure, in the form of a photonic crystal, in a SiCOI obtained with the method of figure 1;
- Figure 7 is a scheme showing the obtention of a photonic structure, in the form of a rib photonic waveguide in a SiCOI obtained with the method of figure 1.

### Detailed description of the invention

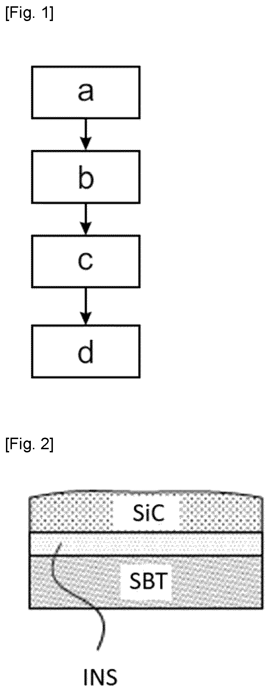

Figure 1 is a block diagram representing the main steps of a method for manufacturing a silicon carbide on insulator (SiCOI) according to the invention.

The method comprises the following steps:
a) providing a substrate SBT,
b) providing a silicon carbide SiC structure,
   at least one of the substrate and of the silicon carbide structure being provided with an electrically insulating layer INS;
c) arranging the silicon carbide SiC structure against the substrate SBT with the electrically insulating layer between the silicon carbide structure and the substrate so as to form a contact between them ;
d) focusing a laser beam LB towards the electrically insulating layer to weld the silicon carbide structure to the substrate, the laser beam being controlled to define one or several welded areas separated by one or several non-welded areas.

Figure 2 represents a SiCOI structure obtained by the method of the invention.

### About the substrate SBT provided at step a)

The substrate SBT may be chosen, in a non-limitative way, amongst silicon (Si substrate, either intrinsic, or n type or p type, eventually with silicon epitaxial layers and/or with ion implanted layers), silicon carbide (SiC substrate, either intrinsic, or n type or p type, eventually with SiC epitaxial layers and/or with ion implanted layers). Alternatively, the substrate SBT may also be a composite material, for example made of SOI (silicon on insulator substrate) providing the possibility to integrate additional electronic functionalities derived from CMOS technology to the SiCOI technology, or for example made of a silicon substrate with on top, an evaporated amorphous Si(a-Si)/SiO₂ DBR structure (DBR for Distributed Bragg Reflector) providing a highly reflective substrate for light (if necessary) in some SiCOI photonic structures like in fiber-based Fabry Perot microcavities.

According to another possibility, the substrate may also be chosen as a material comprising gallium, for example a Gallium Nitride (GaN, either intrinsic or n type or p type) or a Gallium Arsenide (GaAs). Alternatively, the substrate may also be a composite material, for example a Gallium Arsenide (GaAs) substrate comprising a multi-layers Distributed Bragg Reflector (DBR) made of epitaxial layers of III-V arsenide semiconductors (GaAs, InGaAs, AlAs, InAlAs ...), or a GaN substrate comprising a multi-layers Distributed Bragg Reflector (DBR) made of epitaxial layers of III-V nitrides semiconductors (GaN, AIN, GaAlN, ...).

According to another possibility, the substrate may also be chosen as a material comprising Indium (In), for example an Indium Phosphide (InP) substrate. Alternatively, the material may also be a composite material, for example an Indium Phosphide (InP) substrate comprising a multi-layers Distributed Bragg Reflector (DBR) made of epitaxial layers of AlAsSb/Al_{0.04}Ga_{0.96}AsSb.

### About the SiC structure provided at step b)

For the SiC structure provided at step b), it is possible to choose from all the silicon carbide polytypes, in particular from the most widespread 3C SiC, 4H SiC and 6H SiC.

The SiC structure may be completely made of SiC (bulk SiC), or made of a substrate (e.g. of SiC substrate or a GaN substrate or another type of substrate) with an epitaxial layer of SiC.

It is to be noted that the 4H SiC polytype is of very high crystalline quality, with controlled doping, optionally supplemented by doped or undoped epitaxial layers, optionally supplemented by isotopically purified epitaxial layers (e.g. to remove all the nuclear spins from the epitaxial layer, thereby the epitaxial layer, in order to increase the quantum coherence of the electron spins of the color centers located in it), and whose color centers have excellent quantum coherence properties, including both spin coherence and optical coherence. We note that in the case where the 4H SiC polytype is used, the SiC structure may be chosen, in a non-limitative way, either c-plane or a-plane oriented (different orientations of the c-axis of 4H SiC with respect to the normal direction of the 4H SiC sample surface).

### About the electrically insulating layer provided with at least one of the substrate or the SiC structure, before step c)

Preferably, the substrate SBT is provided with the electrically insulating layer. We may in particular have an electrically insulating layer in the form of an oxide layer, such as a SiOx layer and more particularly a SiO₂ layer. Typically, and by way of example only, a silicon substrate will be oxidized by thermal annealing under oxygen from a few tens of nanometers to several hundred nanometers, an oxide layer of the SiOx type can be added to the silicon oxide in order to thicken it, if necessary. This can be achieved by PECVD (Plasma-Enhanced Chemical Vapor Deposition) or LPCVD (Low-Pressure Chemical Vapor Deposition) of SiOx or by thin-film deposition of HSQ (Hydrogen Silses-Quioxane liquid solution) using a spin coating process, followed by thermal annealing at about 550°C for around 2 hours to transform the HSQ into SiOx, in particular SiO2. Similarly, an oxide layer of the SiOx type can be added to any substrate (not made of silicon) either by PECVD or LPCVD deposition of SiOx or by thin-film deposition of HSQ (Hydrogen Silses-Quioxane liquid solution) using a spin coating process, which allows not only planarization, but also provides, after thermal annealing at about 550°C for around 2 hours to transform the HSQ into SiOx, the required oxide layer. If also necessary, any SiOx that has been added can be polished as a preparation before implementing step c).

Alternatively, the SiC structure is provided with the electrically insulating layer. If the insulating layer has to be silicon oxide, a first possibility consists in performing a thermal oxidation of SiC. This can be done by thermal annealing of SiC under oxygen at 1100°C, producing an oxide layer from a few nanometers to several tens of nanometers in thickness. A second possibility, consists in using LPCVD or PECVD deposition of a silicon oxide layer on top of SiC. This deposition can eventually be followed by a polishing step (for example a CMP polishing step).

We may also envisage to have, again before step c), an electrically insulating layer both on the substrate and the SiC structure. The manufacturing of each electrically insulating layer may be done as described above.

### About step c)

The contact between the silicon carbide structure and the substrate may be described as an optical contact. As known by the person skilled in the art, an optical contact (sometimes known as "optical contact bonding") is a way to join two conformal surfaces by intermolecular forces. The contact between the silicon carbide structure and the substrate can be an optical contact on the whole interface (global optical contact). Alternatively, the optical contact can be only local (local optical contact). In this last case a gap of few micrometers or less can stay between the two materials at the other places of the interface.

In practice, to obtain an optical contact, whether it be global or local, the weight of the silicon carbide structure may be sufficient in some cases. Often, a simple pressure (for example manual or with a tip) on the silicon carbide structure to force contact between the corresponding surfaces of the silicon carbide structure and the substrate is sufficient. Nevertheless, a mechanical system or a magnetic system such as magnets can also be used to press the two surfaces one against the other.

The less rough the surfaces, the easier it is to obtain an optical contact between them, locally and also, as the surfaces in contact are accordingly flatter, globally. As a consequence, the surfaces to be brought into contact (whether the case from the SiC, the electrically insulating layer INS or the substrate SBT) preferably present a low roughness, typically of 100nm or less. A step of mechanical polishing may be implemented before step c) to any concerned surface if needed.

### About the laser beam at step d)

During step d), the laser beam LB is preferably focused towards the electrically insulating layer through the silicon carbide structure. SiC is indeed transparent in the infrared domain, and typically a laser beam with a 1030nm wavelength can be used through the SiC structure for the laser welding of the SiC structure to the substrate. The laser welding can be achieved in one or several area(s) where the surfaces are in contact, or further, in an area without contact but only under the condition that the gap is inferior to a few micrometers. This gap dimension can be appreciated, for example, using natural optical fringes, known as Newton rings, when illuminated by white light.

In an alternative way, during step d), the laser beam LB may be focused through the substrate layer, depending on the material it is made of. For example, a laser beam operating at a wavelength of 1550 nm may be used if the substrate is made of silicon.

### Additional step(s)

The method may comprise an additional step consisting of thinning the silicon carbide layer, for example by reactive ion etching, mechanical grinding, mechanical chemical polishing or by a combination of any of them. SiC is available on the market in the form of wafers with a SiC structure thickness which is typically of a few hundreds of microns, generally more than 300 microns. From such a SiC wafer, thinning becomes necessary to be in capacity to use the SiCOl. In such a case, it is possible to implement a thinning indifferently between step b) and c), between step c) and d) or after step d). In an alternative way, we can provide at step b), a SiC structure previously thinned, at an intermediate thickness or to its definitive thickness, ready for use.

Nevertheless, preferably, the method according to the invention will implement, after step b), the following sub-steps, in this order:
- thinning the silicon carbide structure (for example from a commercial wafer), down to a first thickness;
- implementing step c);
- focusing a first laser beam towards said electrically insulating layer, said first laser beam, controlled to define welded areas separated by non-welded areas, having a first beam diameter and a first Rayleigh length;
- thinning again the silicon carbide layer, down to a second thickness smaller than the first thickness;
- focusing a second laser beam towards the electrically insulating layer, said second laser beam, controlled to define welded areas separated by non-welded areas, having a second beam diameter lower than the first beam diameter and a second Rayleigh length lower than the first Rayleigh length.

In this preferred way, the wafer typically presents a thickness of a few hundred of microns, for example more than 300 microns. The first thickness of the SiC structure after the first thinning may then be comprised between 100 and 150 microns. The first laser beam may have a first beam diameter greater than 20 microns and a first Rayleigh length greater than 200 microns. The second thinning therefore allows reaching a second thickness smaller or equal to 20 microns, in particular smaller or equal to 1 micron. Finally, the second laser beam may have a second beam diameter lower than 5 microns and a second Rayleigh length between 20 and 100 microns.

After the sub-step consisting of focusing the second laser beam towards the electrically insulating layer, an additional sub-step consisting of thinning again the silicon carbide, down to a third thickness smaller than the second thickness, may be added. In that case, the first thickness is comprised between 100 and 150 microns, the second thickness is between 1 micron and 20 microns and the third thickness is less than 1 micron. The features of the first laser beam and of the second laser beam are unchanged, namely the first laser beam has a first beam diameter greater than 20 microns and a first Rayleigh length greater than 200 microns and the second laser beam has a second beam diameter lower than 5 microns and a second Rayleigh length lower than 100 microns.

The first laser beam (low resolution) may be performed in the form of points, lines or curves, open (like a U) or closed (like rectangles or more complex closed curves), or any combination of them. Preferentially, the first laser beam is mainly used for laser welding at the periphery of the silicon carbide structure and the substrate, while the second laser beam (for higher resolution of the laser welding) is used to perform laser welding mainly near the center of the silicon carbide structure and the substrate, where one or several SiCOI photonic structures (such as a microdisk cavity, a ring cavity, an optical waveguide, a photonic crystal with or without defects like cavity or waveguide, an optical taper, an optical coupler, a nanobeam, or various combination of them) can be designed and manufactured by a further processing. The second laser beam allows to keep some of the further processed photonic structures bound to the whole SiCOI structure, like a SiCOI microdisk laser welded at its center or like linear waveguides that may be laser welded by passing the laser, either perpendicularly to the waveguiding direction, or parallel to the waveguiding direction (rib waveguide case), depending on laser parameters used for laser welding. In the case of a photonic crystal, with or without defects, the laser welding will be preferentially performed around the area where the photonic crystal has to be fabricated.

### Example: manufacturing of a SiCOI structure of the type SiC/SiO₂/Si(substrate) with the method of the invention.

In this example, we consider an oxide layer present on the Si substrate, the SiC structure having no oxide layer. SiO₂ oxides are particularly interesting as they have a low roughness that favors contact with the SiC structure and thus facilitates the laser welding.

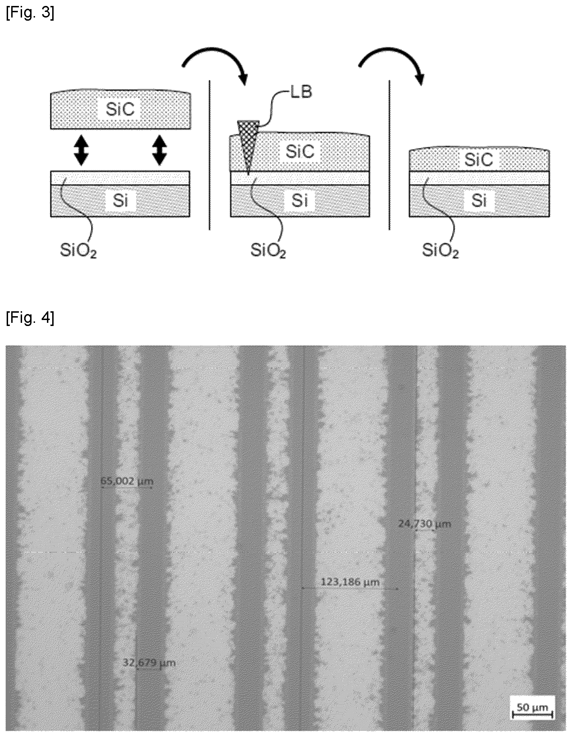

This example is to be read in view of Figure 3, where the left image corresponds to step c), the central image corresponds to a first welding sub-step and the right image to the structure obtained after the second (or eventually third) thinning sub-step.

The first laser welding step is carried out using a lens with a long focal length. It can be made with a weld spot diameter of several tens of microns and a Rayleigh length of a few hundred microns. The laser may be chosen to operate at a wavelength of 1030 nm for which the SiC is transparent. The laser is pulsed and may be used with a repetition rate of between 200 kHz and 2 MHz (or higher up to a few GHz if needed), delivering laser pulses with a typical duration of a few hundreds of fs, the laser having a maximum averaged power of 25 watts. In the present example, the pulse duration if of 300 fs, with an energy E = 10µJ and a repetition frequency of 500 kHz, a scanning speed of 1000 mm/s, focused with a 100 mm lens into a spot 25 µm in diameter. Depending on the material and of the power beam density an autofocusing due to optical Kerr effect may be taken into account. Laser in burst mode can also be considered. It can be useful to minimize the optical Kerr effect and to avoid filamentation in some material The laser beam then reaches the interface with the oxide thin layer with no or low attenuation. The welding is quick but with moderate precision. The laser beam is controlled to define one or several welded areas separated by one or several non-welded areas, the welded areas being for example in the form of a U, of parallel lines, or of a closed curve such as a circle or rectangle. In practice, we can use galvanometric moving mirrors to drive the laser beam while the substrate is kept fixed. It is also possible to move the substrate with translation stages and to keep the laser beam fixed.

The initial SiC structure is generally thick (a few hundred microns thick for bulk SiC substrates for example). Accordingly, before contacting, but also at the end of the first laser welding stage, the SiC structure is thinned, for example by reactive ion etching (RIE or RIE-ICP) using SF₆ gas, or an SF₆ + Argon gas mixture, or any other mixture containing a fluorinated gas. After this thinning, the SiC may achieve a thickness of about 20 microns.

After that, a second laser welding step is carried out using a microscope lens with a shorter focal length than the lens used for the first welding step. It can be made with a spot diameter of less than five microns and a Rayleigh length of a few tens of microns or less, still with a laser operating at a wavelength of 1030 nm for which the SiC structure is transparent. The laser is pulsed with a repetition rate of between 20 kHz and 1 MHz, delivering laser pulses with a typical duration of 300 fs, the laser having a maximum unattenuated power of 3 watts. In the present example, the pulse duration is of 300 fs, with an energy E = 5 µJ and a repetition frequency of 500 kHz, scanning speed of 100 mm/s, focused with a x20 objective lens having a Numerical Aperture NA = 0.4 into a spot 3 µm in diameter. The laser beam focused spot position on the surface is controlled, in particular thanks to imaging means (to observe the sample surface) and mechanical means (preferentially here with translation stages for moving the sample, the laser beam being fixed), allowing to follow the welding areas separated by areas without welding defined previously. This allows to position the laser beam focused spot during this second welding step at the desired position with respect to first marks resulting from the first laser welding step. This second laser welding step may be made in the form of a set of welding points or curves with predefined coordinates distributed over a part or the whole surface, where traces of the first welding step at the level of the oxide and its interface can be used as spatial marks. The second welding is more precise than the first welding. In that aim, the laser can be directed in a fixed direction and the substrate is placed on translation stages to allow precise movement in two or three dimensions. The use of a shorter focal length lens with a larger numerical aperture allows smaller focusing spots.

At the end of this second laser welding stage, the SiC structure is further thinned, for example by reactive ion etching (RIE or RIE-ICP) with SF₆ gas, or a SF₆ + Argon gas mixture, or SF₆ + O₂ or any other mixture containing a fluorinated gas. At the end of this last thinning, the thickness of the SiC structure is typically less than 1 micron.

It is to be noted that here, in the example of a SiCOI structure of the type SiC/SiO₂/Si(substrate), welding occurs as soon as the local temperature reached by the oxide exceeds its melting temperature, i.e. around 1700°C for SiO₂. As the heated zone is very localized, the residual stresses due to expansion differences are minimal. They can however be relaxed by annealing if necessary. As the melting temperature of silicon (substrate) is around 1400°C and that of SiC is around 2700°C, the crystalline silicon is generally amorphized in the immediate vicinity of the focusing spot, while the crystalline structure of SiC is not altered as long as the local temperature reached does not exceed 2700°C.

One signature of this local amorphization is the disappearance of the Raman peak at 521 cm⁻¹ due to crystalline silicon, a disappearance that can be observed in the amorphized silicon below the laser-welded interface using micro-Raman spectroscopy.

This welding of the oxide with the nearby materials in our example and the associated amorphization of the Silicon, near the oxide and at the level of the laser welded areas, also provides another optical signature visible under the optical microscope through the transparent SiC, generally in the form of a darker zone than the unwelded zones. We may refer to Figure 4.

### End of the example.

Defects and stress resulting from the methods of the prior art to produce SiCOI cannot avoid to have defects and stress distributed everywhere in those SiCOI. This is thus a clear advantage of our method to perform laser welding in a spatially non-uniform manner, with areas which are laser welded and others which are not, both clearly identified for further processing taking into account from the beginning, those possible problems of defects and stress related to fabrication of SiCOI, that may otherwise impact the final quality of SiCOI quantum devices.

The marks observed microscopically following laser welding in the vicinity of the oxide interface are very useful as markers for subsequent SiCOI transformation processes, especially once it has been thinned. Indeed, as it will be discussed in further details hereinafter, these visible marks may be used to manufacture photonic structures and/or to implant color centers within the SiCOI, preferentially at the level of a non-welded area where lower defects and a lower stress are expected and thus where quantum spin and optical coherence should be better.

Such further processes to manufacture photonic structures and/or to implant color centers within the SiCOI are now described.

The invention also relates to a method for manufacturing a photonic structure made of silicon carbide on insulator (SiCOI), said method comprising the following steps:
A) manufacturing a silicon carbide on insulator with the method detailed hereinabove,
B) etching at least the silicon carbide structure at the level of at least one non-welded area between the silicon carbide structure and the substrate to form the photonic structure.

Step B) may also imply an etching of the electrically insulating layer, and eventually of the substrate, at the level of at least one non-welded area between the silicon carbide structure and the substrate.

For example, between step A) and step B), the method may comprise the following preparatory steps to step B):
PB1) locating the or each mark left by the or each welded area between the silicon carbide and the substrate (as it can be easily understood: during step A)),
PB2) manufacturing, by lithography, a mask not covering at least one non-welded area between the silicon carbide and the substrate, by taking advantage of the or each mark previously located.

The mask manufactured at step PB2) can be either a negative resist mask, for example made of SU8 resin, or a metal masks, like Ni or Al or another metal mask, or any other mask material with a fluorinated etching contrast with SiC. The important point is to let access to at least one non-welded area to create the photonic structure. The etching of step B) may be a reactive ion etching (RIE or RIE-ICP) of the SiC thin film of the SiCOI through these masks aligned thanks to the laser welding marks let at step A). Artificial intelligence combined with microscopy could also help to recognize the shape of the laser welded marks let at step A) and thus increase the precision of the alignment of the lithography masks.

The deliberate introduction of photonic defects into SiCOI 2D photonic crystals obtained by such a method, introduction made during the etching step of the thinned SiC (for example by removing some planned holes from the design of the 2D photonic crystal) is a method for obtaining optical guides or optical resonators for integrated photonics in SiC, whether quantum or classical. These optical resonators can be of the micro-ring resonator type, for example or nanobeam resonators. In the case of 2D photonic crystals with defects (such as optical guides and/or cavities/resonators), a HF wet etching of the SiOx oxide under the SiC or wet etching with an HF/NH₄F mixture, or a HF vapor etching, is a complementary process that can increase the confinement of the light in the photonic crystals, through a stronger refractive index contrast with air replacing the HF etched SiOx under the SiC.

It should also be noted that optical resonators of the micro-disk or micro-pillar type could also be made from this SiCOI obtained by laser welding and etching, eventually preceded by a lithography step, provided that at least one laser welding spot smaller than five microns and smaller than the diameter of the micro-disk is located 'in the center' (i.e. on the axis of the micro-disk) of these SiCOI micro-disks or micro-pillars.

Thus, after etching beyond the oxide layers, the micro-disk SiCOI optical resonator will remain firmly attached by laser welding to the substrate, preferably made of Silicon.

Partial wet etching of the oxide with HF or with a mixture of HF/NH₄F mixture (wet etching), or etching with HF vapors (which avoids the problems of concentration gradient in etching), can also be carried out afterwards to expose to the air the peripheral area of these micro-disc resonators, which can then support very confined optical modes known as the 'Whispering Gallery Mode' (WGM modes), and this, without removing the laser welding of the oxide with nearby materials on the axis of symmetry of revolution of this type of resonator.

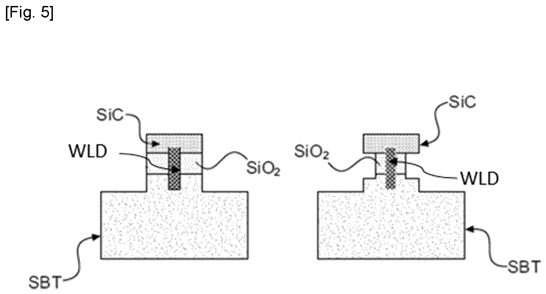

We can refer to figure 5 that represents the modifications of the SiCOI (such as represented at figure 2) with such a manufacturing process of a photonic structure in the form of a SiCOI micro-disk (on the right: final state, on the left, an intermediate state). Possible methods for etching and/or manufacturing a mask have been presented here above. Further details are not necessary as those methods are classical. Nevertheless, in the frame of the invention, one important point is to take advantage of the marks let by the laser welding.

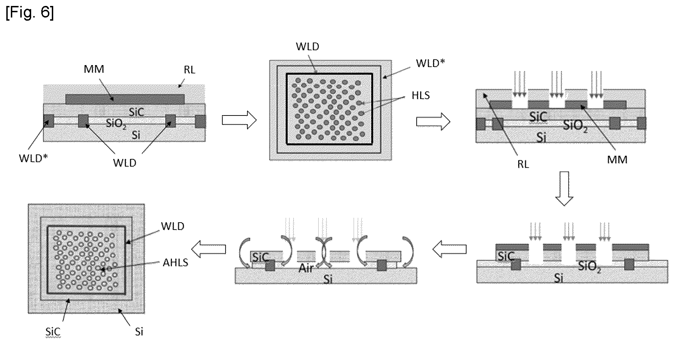

We can also refer to Figure 6 that represents the modifications of the SiCOI (such as represented at figure 2: SiC/SiO₂/Si) with such a manufacturing process of a photonic structure in the form of a SiCOI photonic crystal.

At the first image (upper left-hand corner), we can see a metal mask MM, for example in aluminum, as a square shaped thin film on the SiCOl, as well as two welding areas WLD* (sacrificial, peripheric, welded by the first laser beam) and WLD (internal, welded by the second laser beam).The metal mask MM covers the second welded area WLD, but not the first one WLD*. This peripheric laser welded area WLD* is here only useful for lithography as a mark, and it is sacrificial because it will not remain at the end of the process. Thus, the useful laser welded curve WLD cannot be seen through aluminum at this stage, but the peripheric one WLD* can be seen through an e-beam resist layer RL and through SiC. Indeed, here, the metal mask MM has been covered by an e-beam resist layer RL deposited by spin coating on the metal mask MM.

At the second image (top view), we can see the effect of an e-beam patterning of the resist layer RL and its further development, performed to open holes HLS in the resist layer and then expose some parts of the metal mask MM.

At the third image, local Cl₂ or BCl₃ RIE etching of the metal mask through the holes HLS patterned in the e beam resist is made. Then, the remaining resist layer is removed and local SF₆ RIE etching of SiC through the holes HLS patterned in the metal mask is made, as it can be seen at the fourth image (right-hand lower corner).

Then the remaining metal mask is removed and local HF (wet or vapor) under-etching of SiO₂ located below the SiC is made, taking care to save the useful laser welded area WLD allowing to keep at least locally the SiCOI structure (fifth image), and resulting in a SiC membrane suspended in air, having a periodic array of air holes AHLS, constituting the 2D photonic crystal of SiC (last image, in top view).

It should be noted that the invention also relates to method for manufacturing a photonic structure in a silicon carbide on insulator (SiCOI) structure, said method comprising the following steps:
A) manufacturing a silicon carbide on insulator (SiCOI) structure with the method according to the invention;
B') etching at least the silicon carbide structure at the level of at least one welded area between the silicon carbide structure and the substrate while leaving at least one part of silicon carbide at the level of said at least one welded area between the silicon carbide structure and the substrate, to form the photonic structure.

Step B') mays for example ends to a rib photonic waveguide or to a rib photonic cavity.

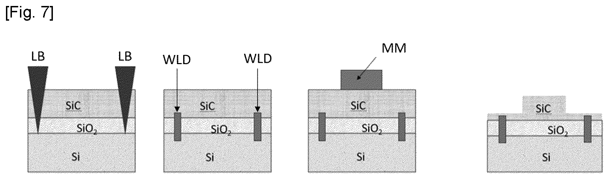

We may refer to Figure 7 that represents the modifications of the SiCOI with such a manufacturing process of a photonic structure in the form of a rib photonic waveguide.

At the first image, we can see a step of manufacturing of a silicon carbide on insulator (SiCOI) structure of the type SiC/SiO₂/Si, including the illustrated step of laser welding (the laser beam LB is represented as a conic shape, and it induces a local welding), as it can be seen in figure 2. Then, we can see a step of thinning (without mask therefore everywhere) by Reactive Ion Etching with SF₆ gas to reach a silicon carbide layer with a thickness inferior or equal to 20 microns. The laser welded areas WLD at the interface are represented by the vertical rectangles. For the manufacturing of the waveguide, we then choose to define a metal mask MM for RIE etching between the (laterally) welded areas. The metal mask is in the form of a line of metal (for example a line of aluminum) that will protect partly the SiC from the subsequent RIE etching with SF₆ gas. During the lithography process, we take advantage of the marks made by laser welded areas at the interface, visible through the photoresist spin coated on SiC using an optical microscope, to determine the area of the photoresist to be irradiated, for example by UV if one use optical lithography.

Finally, Reactive Ion Etching with SF₆ gas during a pre-determined duration is performed everywhere and thus also through the metal mask, leading to different thicknesses of the remaining SiC depending whether it was below the Al mask or not. This SiCOI processing allows to form a SiCOI rib waveguide structure. The aluminum metal mask combined with SF₆ RIE etching produces a step (a "rib") on the SiC layer, as a result of the SF₆ etching rate contrast between SiC and aluminum.

Moreover, this method to manufacture photonic structures within the SiCOI may also comprise an additional step C) consisting of performing ion implantation of the silicon carbide structure at the level of at least one area without welding between the silicon carbide (SiC) structure and the substrate to form one or several color centers in one or several photonic structure(s).

This constitutes an effective method for creating, by means of localized ion implantation, one or more color centers in SiC, the SiC being possibly micro or nano structured by etching or any other process, before or after the creation of color SiC centers by localized ion implantation. Some non-limitative examples of 4H SiC color centers are the negatively charged silicon mono-vacancies color centers VSᵢ₋ (of V2 or V1 type), the neutral divacancies (VV°) and the negatively charged NV⁻ color centers of SiC, all paramagnetic and photoluminescent in those charged states and known for their excellent quantum spin coherence properties in bulk 4H SiC.

Ion implantation of step C) may be made with a focused ion beam (FIB) or a helium ion microscope (HIM), in a convenient manner because in this case it is mainly the ion beam which is moved on the sample, generally fixed during such processing.

The SiCOI to be locally implanted can also of course be placed on a set of multi-axis translation and rotation stages with very high (nanometric) precision and high repeatability, enabling both investigation by microscopy (optical, or electron, or HIM based microscopy) of the SiCOI and further localized ion implantation of the SiCOI, eventually taking advantage of the laser weld marks.

FIB and HIM are smart alternatives to the more standard method for performing ion implantation in photonic devices, which consist in a statistical method, in which, many copies of the same photonic structure are fabricated on the same chip, and holes in mask defined by lithography, here assisted by laser welding marks, are used as apertures for a global macroscopic implantation step of all devices simultaneously. The result of this process is the introduction of color centers in each hole and thus in photonic devices, but with a number of centers per hole given by Poisson statistics. A post implantation analysis by optical microscopy means (by auto correlation of the photoluminescence from each hole for example) and post-selection of the quantum devices fabricated in this manner has thus to be done, for example if one is interested by devices having only one single color center per hole and thus per SiCOI photonic structure. Note that FIB and HIM, while avoiding the use of a mask before local ion implantation, are in general not deterministic method also, in the sense that the precise number of color centers introduced locally by those methods in SiC may also fluctuate from one device to another (it depends in particular on the dose received by SiC). Some post fabrication selection may thus also be necessary in this approach to select some quantum devices, for example those with one single color center.

In addition, in an alternative way, the method according to the invention may comprise an additional step C) consisting of performing electron or neutron irradiation of the silicon carbide structure at the level of at least one non-welded area between the silicon carbide structure and the substrate to form color centers in a photonic structure, and eventually performing a thermal annealing. Indeed, good quality color centers can be created by electron irradiation of the SiC. With this alternative approach, all the SiC is irradiated, so the electron or neutron beam is rarely localized (contrary to the other techniques like FIB or HIM). Nevertheless, as the probability of color centers being created is low per electron or per neutron, the concentration of color centers created is low in SiC. It may be of interest for some applications. We can typically have, for example, an electron irradiation of 5 MeV / 2 kGy.

In addition also, in an alternative way, the method according to the invention may comprise an additional step C) consisting of performing laser irradiation of the silicon carbide structure at the level of at least one non-welded area between the silicon carbide structure and the substrate in such a way that laser welding is avoided, in order to form color centers in a photonic structure, and eventually performing a thermal annealing after this process.

This color center fabrication method by laser has already been demonstrated by several teams , it has the advantage of being also local, like HIM and FIB, but it seems also to provide lower quality color centers in bulk 4H SiC (in terms of quantum coherence) compared to those introduced by ion implantation or electron irradiation methods.

Whatever the method used (FIB, HIM, global ion implantation through holes in mask, or electron and/or neutron irradiation or laser irradiation) eventually, after step C), we can implement an additional step D) consisting of performing a thermal annealing under neutral gas, for example under argon gas or nitrogen gas. This often improves the quality and/or number of color centers introduced in SiC by a given number of implanted ions or send electrons.

Eventually also, another additional step can be implemented between step A) and step C), consisting of performing a thermal annealing of the SiCOI at 1100°C under pure oxygen gas during a predetermined duration. This duration will be typically of 30 minutes or more, resulting in at least few nm of thermal SiO₂ (oxidation) formed on the SiC surface and also resulting in the removal of any pre-existing unwanted color center of V1 or V2 single silicon vacancy type in the SiC of the SiCOl, that may have been introduced inside SiC from the beginning, that is from the growth of the starting SiC material.

For example, to form rectangular waveguides in a SiC/SiO2/Si structure (these waveguides are guided by contrasting optical refractive indices, taking n_{SiC} = 2.6, n_{SiO2} = 1.45 and nₐᵢᵣ = 1 for the air surrounding them here, on the top and on the side faces) having a single-mode TM00 at 917 nm, wavelength of the zero-phonon photoluminescence emission line, known as the ZPL, of the color centers known as V2 - negatively charged silicon mono vacancies of 4H SiC in SiC sites with local cubic symmetry (which can be used as quantum bits of electronic spins and/or as sources of single photons), we will start with guides of width w = 528 nm = 3x176 nm thinned down to a height h = 204 nm. With such dimensions, these guides in SiC/SiO2/Si will make it possible waveguiding the off-resonance excitation laser at 785 nm of the V2, but also waveguiding of the photoluminescence on the ZPL line of V2 at 917 nm in the TM00 single mode of such a waveguide, and finally to guide the photoluminescence of V2 on the lines of photoluminescence with phonon emission (PSB for Phonon Side Bands), from 940 nm to 1040 nm, also in the TM00 single mode of the guide. One of the advantages of using this type of TM00 single-mode guide for quantum applications using V2 (as spin qubits or sources of single photons) is that the electric field of this TM00 mode is parallel to the electric dipole of the color centers V2 of the 4H SiC contained in this SiCOI (the electric dipole of V2 is parallel to the c-axis of the 4H SiC), so that the coupling of the photoluminescence of V2 to the TM00 mode of this waveguide is favorable and therefore also the guiding of the V2 photoluminescence to another area of interest in a SiCOI on-chip device, for example to the photoluminescence collection zone, and ultimately potentially also to a photoluminescence detection zone. In such a case of the SiCOI waveguide design, and when the silicon substrate is n-type or p-type doped, one will have to choose a thickness of the SiO₂ oxide thin layer that is equal to or greater than 300 nm typically, to avoid attenuation of the TM00 guided mode when propagating in the SiCOI waveguide (attenuation otherwise possible due to silicon doping for smaller SiO₂ thicknesses).

The solution proposed in the present invention to manufacture a SiCOI has several advantages:
- no defects created by high-dose ion implantation of SiC, as it is the case with the well-known Smart Cut^{™} process,
- few and localized stresses at known positions introduced between SiC and the substrate (for example, made of Si),
- visible laser welding marks, with an optical microscope, that can be used for additional steps (etching through a mask defined by lithography and/or localized implantation, etc.) of manufacturing photonic structures within the SiCOI and/or color centers,
- high reproductibility of the manufacturing process thanks to precise control of the laser process parameters,
- resistance to high-temperature thermal annealing of the SiCOI (if any), in particular resistance of the laser welding areas,
- a relatively low-cost laser process, because the SiCOI with a thick starting SiC structure (in general with a starting thickness above 100 microns and up to 500 microns typically), obtained by non-uniform laser welding with a lens and laser scanning, is produced relatively quickly and with a low energy budget.

Finally, it should be noted that SiCOI can be used as an integrated photonics platform because it provides complete 3D optical confinement of light thanks to the contrasting refractive indices of the SiCOI and of its photonic structures. This avoids the difficulty of fabricating photonic structures entirely in SiC using other, much more complex methods such as laser etching of SiC, tilted reactive ion etching of SiC and/or photo/electrochemical etching of SiC.

The invention may find interest in many applications, for example for obtaining integrated photonics components, whether quantum or classical components. Quantum components containing color centers are used for quantum sensors, for sources of single photons (quantum light source) and for quantum processors. Other possible applications include power electronics (a long-standing application for SiC, with many SiC components found in electric vehicles in particular) or classical nonlinear optics (thanks to the optical non-linearities of 4H SiC in particular), for example for multiplexing in conventional optical communication, or also to produce laser light sources.

## Claims

1. A method for manufacturing a silicon carbide on insulator (SiCOI) structure, said method comprising the following steps:
a) providing a substrate (SBT),
b) providing a silicon carbide (SiC) structure,
at least one of the substrate and of the silicon carbide structure being provided with an electrically insulating layer (INS);
c) arranging the silicon carbide (SiC) structure against the substrate (SBT) with the electrically insulating layer between the silicon carbide structure and the substrate so as to form a contact between them ;
d) focusing a laser beam (LB) towards the electrically insulating layer to weld the silicon carbide structure to the substrate, the laser beam being controlled to define one or several welded areas separated by one or several non-welded areas.

2. The method according to claim 1, wherein the substrate (SBT) is chosen among:
- a material comprising silicon, for example silicon, silicon carbide or a composite structure such as a silicon-on- insulator or a silicon substrate comprising a Si(Si-a)/SiO₂ multi-layers Distributed Bragg Reflector (DBR);
- a material comprising gallium, for example a Gallium Nitride (GaN) or Gallium Arsenide (GaAs), or a Gallium Arsenide (GaAs) substrate comprising a multi-layers Distributed Bragg Reflector (DBR) made of epitaxial layers of III-V arsenide semiconductors, a GaN substrate comprising a multi-layers Distributed Bragg Reflector (DBR) made of epitaxial layers of III-V nitrides semiconductors;
- a material comprising Indium (In), for example an Indium Phosphide (InP) substrate or an Indium Phosphide (InP) substrate comprising a multi-layers Distributed Bragg Reflector (DBR) made of epitaxial layers of AlAsSb/Al_{0.04}Ga_{0.96}AsSb.

3. The method according to one of the preceding claims, wherein the silicon carbide (SiC) structure is made of a silicon carbide polytype, for example, 4H, 6H or 3C silicon carbide polytype.

4. The method according to one of the preceding claims, wherein the substrate (SBT) is provided with the electrically insulating layer (INS).

5. The method according to one of the preceding claims, wherein the electrically insulating layer (INS) is made of a material chosen among: silicon oxide (SiOx) such as silicon dioxide (SiO₂), silicon nitride (Si₃Nx) such as trisilicon tetranitride (Si₃N₄), alumina (Al₂O₃), titanium dioxide (TiO₂), zinc oxide (ZnO), magnesium oxide (MgO), strontium titanate (SrTiO₃), or a combination of electrically insulating oxides, for example made of any combination of the precited oxide materials.

6. The method according to one of the preceding claims, wherein during step d), the laser beam is focused towards the electrically insulating layer through the silicon carbide structure.

7. The method according to one of the preceding claims, comprising at least one additional step consisting of thinning the silicon carbide (SiC) layer, for example by reactive ion etching, mechanical grinding, mechanical chemical polishing or by a combination of any of them.

8. The method according to one of the preceding claims, said method implementing the following sub-steps, after step b), in this order:
- thinning the silicon carbide (SiC) structure, down to a first thickness;
- implementing step c);
- focusing a first laser beam towards said electrically insulating layer, said first laser beam, controlled to define welded areas separated by non-welded areas, having a first beam diameter and a first Rayleigh length;
- thinning again the silicon carbide (SiC) layer, down to a second thickness smaller than the first thickness;
- focusing a second laser beam towards the electrically insulating layer, said second laser beam, controlled to define welded areas separated by non-welded areas, having a second beam diameter lower than the first beam diameter and a second Rayleigh length lower than the first Rayleigh length.

9. The method according to the preceding claim, wherein the silicon carbide (SiC) structure provided at step b) having a thickness greater than 200 microns, the first thickness is comprised between 100 and 150 microns and the second thickness is smaller or equal to 20 microns, in particular smaller or equal to 1 micron.

10. The method according to claim 8, said method further implementing, after the sub-step consisting of focusing the second laser beam towards the electrically insulating layer, an additional sub-step consisting of thinning again the silicon carbide, down to a third thickness smaller than the second thickness.

11. The method according to claim 10, wherein the silicon carbide (SiC) structure provided at step b) having a thickness greater than 200 microns, the first thickness is comprised between 100 and 150 microns, the second thickness is between 1 micron and 20 microns and the third thickness is less than 1 micron.

12. The method according to one of the claims 8 to 11, wherein:
- the first laser beam has a first beam diameter greater than 20 microns and a first Rayleigh length greater than 200 microns;
- the second laser beam has a second beam diameter lower than 5 microns and a second Rayleigh length lower than 100 microns.

13. The method according to one of the claims 8 to 12, wherein the first laser beam is controlled to weld peripheral areas of the silicon carbide structure and of the substrate while the second laser beam is controlled to weld center areas of the silicon carbide structure and of the substrate.

14. A method for manufacturing a photonic structure in a silicon carbide on insulator (SiCOI) structure, said method comprising the following steps:
A) manufacturing a silicon carbide on insulator (SiCOI) structure with the method according to one of the preceding claims;
B') etching at least the silicon carbide structure at the level of at least one welded area between the silicon carbide structure and the substrate while leaving at least one part of silicon carbide at the level of said at least one welded area between the silicon carbide structure and the substrate, to form the photonic structure, for example a rib photonic waveguide or a rib photonic cavity.

15. A method for manufacturing a photonic structure in a silicon carbide on insulator (SiCOI) structure, said method comprising the following steps:
A) manufacturing a silicon carbide on insulator (SiCOI) structure with the method according to one of the claims 1 to 13;
B) etching at least the silicon carbide structure at the level of at least one non-welded area between the silicon carbide structure and the substrate, to form the photonic structure.

16. The method according to claim 15, comprising the following preparatory steps to step B), between step A) and step B):
PB1) locating the or each mark left by the or each welded area between the silicon carbide structure and the substrate,
PB2) manufacturing, by lithography, a mask not covering at least one non-welded area between the silicon carbide and the substrate, by taking advantage of the or each mark previously located.

17. The method according to claim 15 or 16, wherein step B) also implies etching of the electrically insulating layer, and eventually of the substrate, at the level of at least one non-welded area between the silicon carbide structure and the substrate.

18. The method according to the claim 17 depending on claim 16, wherein the electrically insulating layer being made of silicon oxide (SiOx), step B) consists of etching by reactive ion etching the silicon carbide structure through the mask defined by lithography until at least reaching the silicon oxide electrically insulating layer, and then etching at least partially the silicon oxide electrically insulating layer with a HF solution or with HF vapors.

19. The method according to one of the claims 14 to 18, said method comprising an additional step consisting of:
C) performing ion implantation of the silicon carbide structure at the level of at least one non-welded area between the silicon carbide structure and the substrate to form at least one color center in a photonic structure, said step being for example made with a focused ion beam or a helium ion microscope;
and eventually another additional step implemented after step C) consisting of:
D) performing a thermal annealing under neutral gas, for example under argon or nitrogen gas, to activate one or several color centers.

20. The method according to one of the claims 14 to 18, said method comprising an additional step consisting of:
C) performing electron irradiation, or neutron irradiation, or laser irradiation in such a way that laser welding is avoided, of the silicon carbide structure at the level of at least one non-welded area between the silicon carbide structure and the substrate to form at least one color center in a photonic structure, and eventually performing a thermal annealing.

21. The method according to claim 19 or 20, said method comprising an additional step, between step A) and step C), consisting of performing a thermal annealing of the SiCOI at 1100°C under oxygen during a predetermined duration.
